# EUROPEAN PATENT SPECIFICATION

(11) **EP 1 402 542 B1**
(45) Date of publication and mention of the grant of the patent: **26.09.2007**
(21) Application number: 02748067.2
(22) Date of filing: 02.07.2002
(51) Int. Cl.: G21K 1/06, G02B 5/28, G02B 1/10

(54) **PASSIVATING OVERCOAT BILAYER**
ZWEILAGIGE SCHUTZSCHICHT
BICOUCHE DE FINITION A L'ETAT PASSIF

(30) Priority: 03.07.2001 US 898833; 01.02.2002 US 66108
(43) Date of publication of application: 31.03.2004
(73) Proprietor: EUV Limited Liability Corporation, Santa Clara, CA 95052 (US)
(72) Inventor: BAJT, Sasa, Livermore, CA 94550 (US); FOLTA, James, A., Livermore, CA 94550 (US); SPILLER, Eberhard, A., Livermore, CA 94550 (US)
(74) Representative: Ebner von Eschenbach, Jennifer
(86) International application number: PCT/US2002/021128
(87) International publication number: WO 2003/005377

(56) References cited:
- EP-A- 1 065 568
- EP-A- 1 150 139
- WO-A-00/73823
- WO-A-02/054115
- WO-A-02/059905
- US-A- 5 958 605
- US-B1- 6 229 652
- TAKENAKA H ET AL: "HEAT-RESISTANCE OF MO/SI MULTILAYER EUV MIRRORS WITH INTERLEAVED CARBON BARRIER-LAYERS" OSA TRENDS IN OPTICS AND PHOTONICS, WASHINGTON, DC, US, vol. 4, 1 May 1996 (1996-05-01), pages 169-172, XP008007480 ISSN: 1094-5695
- MONTCALM C ET AL: "MULTILAYER REFLECTIVE COATINGS FOR EXTREME-ULTRAVIOLET LITHOGRAPHY" PROCEEDINGS OF THE SPIE, SPIE, BELLINGHAM, VA, US, vol. 3331, February 1998 (1998-02), pages 42-51, XP000908927 cited in the application

## Description

The United States Government has rights in this invention pursuant to Contract No. W-7405-ENG-48 between the United States Department of Energy and the University of California for the operation of Lawrence Livermore National Laboratory.

### BACKGROUND

### Field

The present disclosure relates to optimizing capping layers for EUVL (extreme ultraviolet) multilayer reflective coatings used in extreme ultraviolet or soft x-ray lithography applications.

### Description of Related Art

Extreme ultraviolet (EUV) and soft x-ray projection lithography make use of optical elements with highly reflective multilayer coatings. These multilayer coatings typically consist of alternating layers of molybdenum (Mo) and silicon (Si) or molybdenum and beryllium (Be). High EUV reflectivity is essential for lithography applications. A critical limitation to achieving the maximum theoretical peak reflectivity is the oxidation and corrosion of the top layers, which both increases the absorption and degrades the phase coherence of the reflection from these layers.

Although there have been numerous investigations of carbon-based, boron carbide-based, and silicon-based multilayer coatings for EUV mirrors, there has been little work on environmental effects (e.g., oxidation and corrosion) of these structures. Underwood et al. (Applied Optics 32:6985 (1993)) investigated the aging effects of Mo-Si multilayers by monitoring the decrease in reflectivity with time. Their experimental results showed a degradation of the Mo--Si multilayer reflectance caused by the oxidation of the topmost layer of molybdenum. Underwood et al. identified the oxidation of the molybdenum layer as a potential problem in soft x-ray projection lithography. The proposed solutions were to make silicon the topmost layer, to store the optical elements in an inert atmosphere or vacuum, or to remove the oxidized surface by sputtering or chemical etching. Undenvood et al. did not investigate the use of passivating layers.

Mo/Si multilayers with Mo as the top layer have the highest theoretically possible reflectivity; however, Mo is not stable in air and therefore Mo/Si multilayers for EUV optics are usually capped with a Si top layer with a loss in reflectivity of 1.3%. After exposure to air, this layer partly oxidizes and forms SiO₂ that absorbs EUV light and reduces the reflectance of the multilayer by about another 1-2 %. This reflectance of Si capped multilayers will remain unchanged for years if the multilayers are kept at room temperatures. See C. Montcalm, S. Bajt, P. B. Mirkarimi, E. Spiller, F. J. Weber, and J. A. Folta, in "Emerging Lithographic Technologies II", ed. Y. Vladimirsky, SPIE Vol 3331, 42-51 (1998). However, in a working EUV lithography tool the coatings are exposed to EUV illumination in the presence of low pressure background gases including water, oxygen, and hydrocarbons. L. Klebanoff et al., M. Wedowski et al. references have shown that the reflectance of Si capped Mo/Si multilayers decreased as a function of EUV illumination dose and the amount of water vapor and other background gases in the system.

U.S. Patent No. 5,958,605, titled "Passivating Overcoat Bilayer For Multilayer Reflective Coatings For Extreme Ultraviolet Lithography", discloses a passivating overcoat bilayer that is used for multilayer reflective coatings for extreme ultraviolet (EUV) or soft x-ray applications to prevent oxidation and corrosion of the multilayer coating, thereby improving the EUV optical performance. The overcoat bilayer comprises a layer of silicon or beryllium underneath at least one top layer of an elemental or a compound material that resists oxidation and corrosion. Materials for the top layer include carbon, palladium, carbides, borides, nitrides, and oxides. The thicknesses of the two layers that make up the overcoat bilayer are optimized to produce the highest reflectance at the wavelength range of operation. Protective overcoat systems comprising three or more layers are also possible.

EP 1 065 568 A2 discloses a EUV-Lithographic projection apparatus comprising an optical element with a capping layer.

EP 1 150 139 A2 is an Article 54(3) EPC European application directed to a multilayer system with a protecting layer system and production method.

WO 02/054115 A2 is an Article 54(3) EPC European application directed to a self-cleaning optic for extreme ultraviolet lithography.

### SUMMARY

The present invention relates to an overcoat bilayer and a method of forming an overcoat bilayer as recited in the independent claims. Additional embodiments are recited in the dependent claims.

It is an object of the present invention to provide a passivating overcoat bilayer for a multilayer reflective coating designed for use in extreme ultraviolet or soft x-ray applications.

It is another object of the invention to provide a bottom overcoat layer that prevents diffusion of a top overcoat layer into the top layer of a multilayer reflective coating.

It is another object of the invention to provide a top overcoat layer made of material that resists oxidation and corrosion and protects a multilayer reflective coating from oxidation.

These and other objects will be apparent based on the disclosure herein.

The present invention is a passivating overcoat bilayer for multilayer reflective coatings for soft x-ray or extreme ultraviolet applications and the method for making such layers. These passivating layers are useful for reflective optical coatings for soft x-ray and extreme ultraviolet wavelengths in applications such as microscopy, astronomy, spectroscopy, laser research, laser cavities and optics, synchrotron optics, and projection lithography.

A passivating overcoat bilayer (also called a "capping" bilayer) is deposited on top of a multilayer coating to prevent oxidation and corrosion of the multilayer coating, thereby improving the EUV optical performance. The multilayer coating can comprise alternating layers of a variety of materials, such as molybdenum-silicon, molybdenum carbide-silicon, molybdenum-beryllium, and molybdenum carbide-beryllium. The passivating bilayer comprises a diffusion resistant layer underneath at least one top layer of an elemental material or compound that resists oxidation and corrosion. Oxidation resistant materials for the top layer (or layers) may include pure elements, such as Ru, Zr, Rh or Pd, and similar materials or compound materials. Diffusion resistant materials for the bottom layer include B₄C, and similar materials or compound materials.

By way of unclaimed example, diffusion resistant materials can also include Mo, carbon and similar materials or compound materials.

The thickness of each layer that makes up the overcoat bilayer is in the range of about 0.5 to 7 nanometers, and the thicknesses are selected to produce the highest reflectance at the EUV wavelength range of operation. The thickness of the overcoat bilayer will typically be different from the thickness of the pairs of alternating layers in the underlying multilayer coating. The thickness of the two layers in the overcoat are individually optimized so as to provide sufficient chemical protection and to maximize EUV optical performance:

### BRIEF DESOUPTION OF THE DRAWINGS

Figure 1 shows a passivating overcoat bilayer on a multilayer reflective coating.
Figure 2 shows an unclaimed embodiment that uses a diffusion barrier of Mo under a Ru layer.
Figure 3 shows optimization of the thicknesses of Ru and Mo to obtain the highest reflectances.
Figure 4A shows an embodiment that provides a diffusion barrier of B₄C under the Ru layer.
Figure 5 shows the optimum B₄C barrier thickness is a tradeoff between reflectance and interdiffusion.
Figure 6 shows the reflectance as a function of wavelength of a RujB₄Cj5i capping layer system and a Ru/Mo capping layer system where the Ru layers are 22 nm thick.

### DETAILED DESCRIPTION OF THE PREFERRED EMBODIMENTS

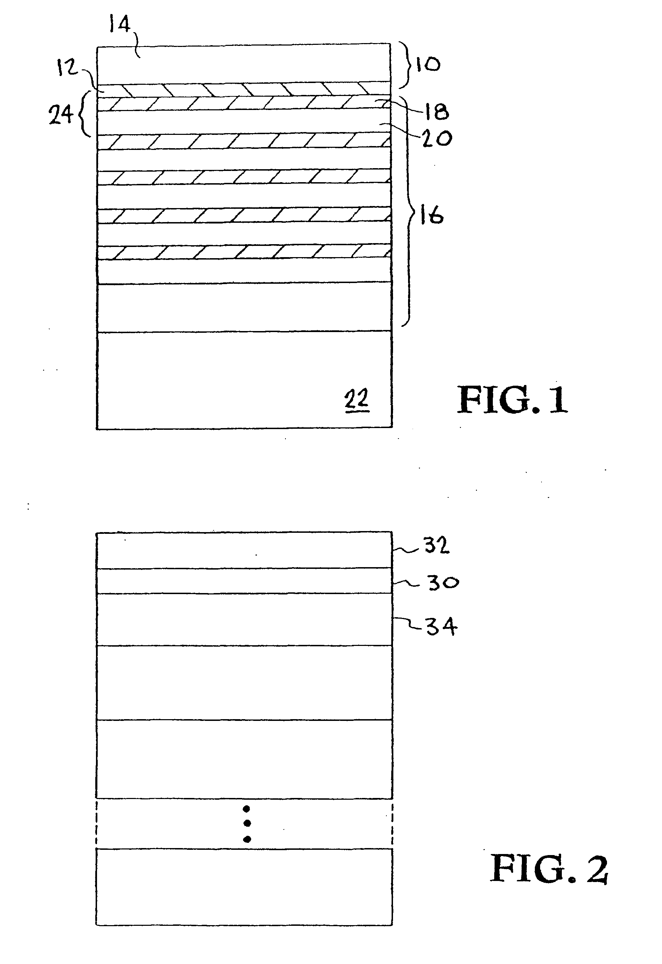

The present invention is a passivating overcoat bilayer for a multilayer reflective coating and an unclaimed example is shown schematically in Figure 1. The overcoat bilayer 10 is made up of a top layer 14, and a bottom layer 12. Top layer 14 comprises a material that resists corrosion and oxidation and protects the underlying layers from oxidation. The bottom layer 12 is deposited on a multilayer coating 16, which typically comprises alternating layers of an absorber material 18 and a spacer material 20. The multilayer coating 16 is deposited on a substrate 22. Bottom layer 12 comprises a material that prevents diffusion of the top layer 14 into the top layer 18 of the multilayer coating 16. The present invention contemplates including a plurality of components and layers within top layer 14 and/or bottom layer 12.

Ru is very stable against oxidation in the environment of a EUV camera. However, a loss in reflectance of 1%- 5% is observed over the standard reference coating. This loss is due to the diffusion of Ru and Si and the formation of ruthenium suicide. For a successful capping layer system, an additional layer that acts as diffusion barrier between the Ru and the underlying structure is therefore needed. Other elements that can be substituted for Ru in the present invention include Zr, Rh and Pd and similar materials and compounds.

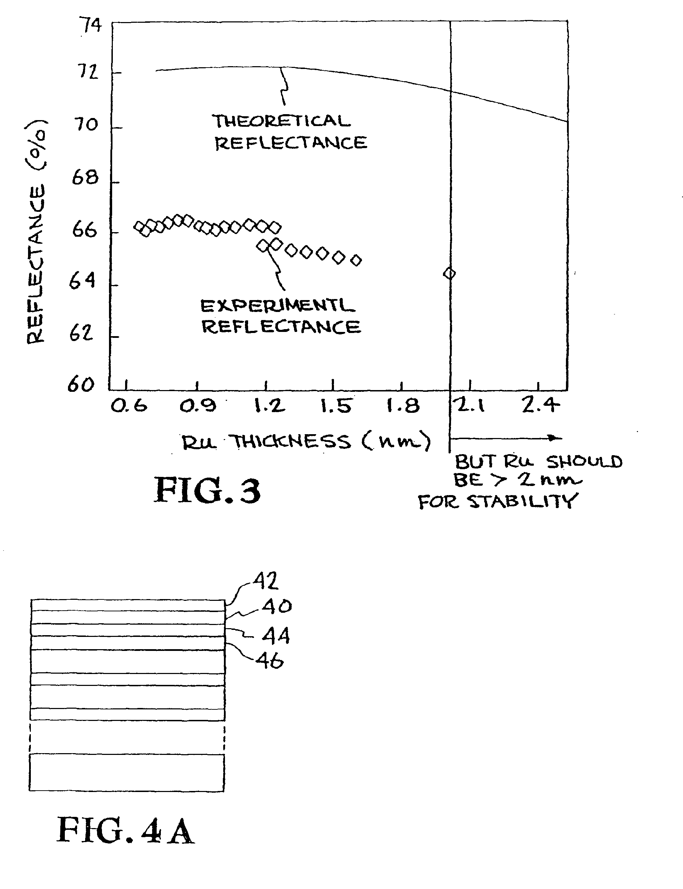

The embodiments discussed herein contain both the oxidation protection and the diffusion barrier. Both systems use a top layer of Ru as the protection against oxidation. Figure 2 shows an embodiment that uses a diffusion barrier 30 of Mo under the Ru layer 32 and on top of the last Si layer 34 in the first system. By way of unclaimed example, the molybdenum layer acts as the diffusion barrier between the Ru layer and the Si layer still by way of unclaimed example. Multilayers capped with 1.3 nm of Mo and between 0.6 nm and 2 nm of Ru have been produced. This embodiment has measured over 67% reflectance. Figure 3 shows optimization of the thicknesses of Ru and Mo to obtain the highest reflectances.

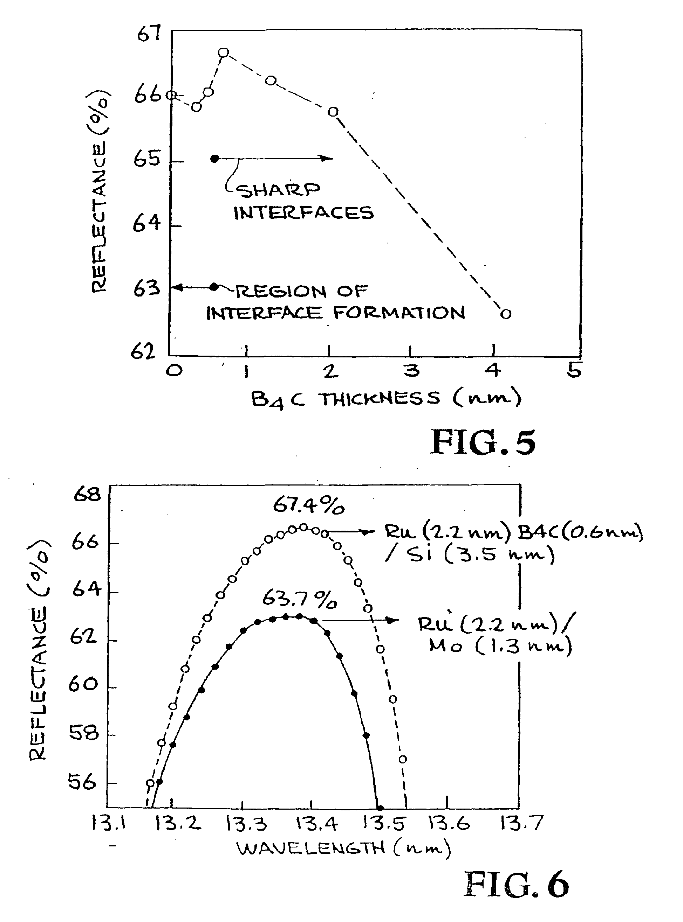

Figure 4A shows an embodiment that provides a diffusion barrier 40 of B₄C under the Ru layer 42 and on top of the last Si layer 44, which is on Mo layer 46. Ru/B₄C multilayers form very smooth and compositionally abrupt interfaces. Thermal annealing at 100° and 250° C produced no measurable change in the reflectance. A theoretical calculation shows a 2-3% reflectance loss if the last Si layer is replaced with B₄C due to the less favorable optical properties of B₄C in the EUV energy range. Experimental data support this prediction. However, this loss can be greatly reduced by replacing only the top part of the last Si layer with B₄C, as shown in Figure 4A. Experiments exploring how far the thickness of B₄C can be reduced have shown that the boron carbide layer must be at least 0.6 nm or thicker. The expected reflectance loss is only 0.6% if B₄C replaces 1/3 of the last Si layer. In this case boron carbide is about 1.3 nm thick The experimental data in Figure 5 shows that the optimum B₄C barrier thickness is a tradeoff between reflectance and interdiffusion. Figure 6 shows the reflectance as a function of wavelength of a Ru/B₄C/Si capping layer system and an unclaimed Ru/Mo capping layer system where the Ru layers are 22 nm thick.

Referring again to Figure 1, a multilayer coating 16 that is designed for applications in extreme ultraviolet (EUV) lithography is typically made of a periodic stack of 40-100 alternating layers of molybdenum (Mo) and silicon (Si), or molybdenum and beryllium (Be). Although other structures are possible (e.g., non-periodic stacks, multilayer stacks with other materials or with more than two materials), the combinations of Mo and Si in one case and Mo and Be in another case, exhibit unusually high normal incidence reflectivity (at least 65%) in the EUV wavelength region (i.e., less than about 15 nanometers). It should be recognized that the Mo in the Mo/Si multilayer structures could be replaced with an absorber layer comprising another material. For example, the Mo can be replaced with molybdenum carbide or Mo₂C. It should also be appreciated that the Mo in a Mo/Be multilayer structure can be replaced by MoRu.

In two of the embodiments discussed, the bottom layer 12 of the overcoat bilayer 10 is made up of either B₄C (claimed embodiment) or Mo (unclaimed embodiment). The top layer 14 is deposited or grown on the bottom layer 12 and comprises Ru, which is a material that resists oxidation and corrosion, and has a low chemical reactivity with common atmospheric gas species such as oxygen, nitrogen, and water vapor. For purposes of this disclosure, "deposition" of the top layer is intended to encompass the concepts of both "depositing" and "growing". This top layer 14 serves to chemically passivate and protect the underlying multilayer coating 16 and to preserve the high reflectance of the coating.

The passivating overcoat can be grown using a vapor phase deposition technique (e.g., sputtering). This method can be incorporated into the multilayer deposition system (e.g., magnetron sputtering with argon plasma) so that the multilayer stack can be encapsulated in situ without exposure to the atmosphere. Alternatively, the overcoat can be grown by chemical reaction.

The thicknesses of the bottom layer 12 and the top layer 14 of the overcoat bilayer 10 are chosen to produce the highest reflectance and offer high oxidation resistance at the EUV wavelength of operation, in a similar manner to how the thicknesses of both layers in the underlying periodic multilayer stack 16 were determined.

As discussed in U.S Patent No. 3,887,261, titled "Low-loss reflection coatings using absorbing materials", the best reflecting multilayer geometry is usually a quarter-wave stack, where the optical thickness of each layer is equal to a quarter of the wavelength of interest at normal incidence. (The optical thickness of a layer is the product of the geometrical or metric thickness and the refractive index of the material.) In the quarter-wave stack, the beams reflected from each interface are in phase and add constructively. This design is ideal when both materials in the stack are non-absorbing, and still remains the best when the extinction coefficients of the two materials are similar. However, when the absorption of one of the two materials is larger, as in the case of EUV multilayer mirrors, the design of the stack must be modified to reduce the overall absorption. The thickness of the absorber is reduced, while the period thickness 24 is kept constant. Therefore, thicknesses are determined by the trade-off between maximizing the constructive interference of the beams reflected at each interface and minimizing the overall absorption to enable more interfaces to contribute to the reflectance.

In the present invention, the thickness of the overcoat bilayer 10 is adjusted to provide the best phase matching with the underlying multilayer coating 16 in order to achieve the highest EUV reflectance while maintaining the highest oxidation resistance. For the Mo/Si and Mo/Be systems, the thickness of each layer in the overcoat bilayer is in the range of 0.5 to 7 nanometers.

In this disclosure there has been discussed a new capping multilayer structure for EUV-reflective Mo/Si multilayers consisting of two layers: A top layer that protects the multilayer structure from the environment and a bottom layer that acts as a diffusion barrier between the top layer and the structure beneath. One embodiment combines a first layer of Ru with a second layer of B₄C. An unclaimed embodiment combines a first layer of Ru with a second layer of Mo. These embodiments have the additional advantage that the reflectivity is also enhanced. Ru has the best oxidation resistance of all materials investigated so far. B₄C is an excellent barrier against silicide formation while the silicide layer formed at the Si boundary is well controlled.

The foregoing description of the invention has been presented for purposes of illustration and description and is not intended to be exhaustive or to limit the invention to the precise form disclosed. Many modifications and variations are possible in light of the above teaching. The embodiments disclosed were meant only to explain the principles of the invention and its practical application to thereby enable others skilled in the art to best use the invention in various embodiments and with various modifications suited to the particular use contemplated. The scope of the invention is to be defined by the following claims.

## Claims

1. A passivating overcoat bilayer on a multilayer reflective coating designed for use in extreme ultraviolet or soft x-ray applications, comprising:
a multilayer reflective coating comprising a plurality of alternating layers of a spacer material (44) and an absorber material (46), wherein said multilayer reflective coating comprises a topmost layer (44) having a top surface and a bottommost layer having a bottom surface, wherein said topmost layer (44) comprises said spacer material, said spacer material being silicon;
a substrate, wherein said bottom surface of said multilayer reflective coating is deposited on said substrate;
a bottom overcoat layer (40) deposited on said top surface of said multilayer reflective coating; and
a top overcoat layer (42) deposited on said bottom overcoat layer, wherein said bottom overcoat layer comprises a first material that prevents diffusion of said top overcoat layer into said topmost layer of said multilayer reflective coating, wherein said first material is B₄C, or any combination thereof, wherein said top overcoat layer comprises a second material that resists oxidation and corrosion and protects said multilayer reflective coating from oxidation, wherein said second material is selected from the group consisting of Ru, Zr, Rh, Pd, and any combination thereof, wherein said top overcoat layer and said bottom overcoat layer of said overcoat bilayer have optimum thicknesses selected such that reflectance of extreme ultraviolet or soft x-ray wavelengths is optimized at the wavelength range of operation and resistance to oxidation and corrosion is selected to preserve such reflectance.

2. The overcoat bilayer of claim 1, wherein said top overcoat layer and said bottom overcoat layer have thicknesses that maximize the normal incidence reflectance at an operating wavelength of less than about 15 nanometers.

3. The overcoat bilayer of claim 1, wherein said top overcoat layer has a thickness ranging from about 0.5 nanometers to about 7 nanometers.

4. The overcoat bilayer of claim 1, wherein said bottom overcoat layer has a thickness ranging from about 0.5 nanometers to about 7 nanometers.

5. The overcoat bilayer of claim 1, wherein said absorber material comprises molybdenum.

6. The overcoat bilayer of claim 1 wherein said. plurality of alternating layers is an even plurality of alternating layers.

7. A method for forming a passivating overcoat bilayer on a multilayer reflective coating designed for use in extreme ultraviolet or soft x-ray applications, comprising:
providing a multilayer reflective coating comprising a plurality of alternating layers of a spacer material (44) and an absorber material (46), wherein said multilayer reflective coating comprises a topmost layer (44) having a top surface and a bottommost layer having bottom surface, wherein said topmost layer (44) comprises said spacer material, said spacer material being silicon;
providing a substrate, wherein said bottom surface of said multilayer reflective coating is deposited on said substrate;
depositing on said top surface of said multilayer coating a bottom overcoat layer (40) comprising a first material that will reduce or prevent interdiffusion, said first material being B₄C, or any combination thereof; and
depositing on said bottom overcoat layer a top overcoat layer (42) comprising a second material that resists oxidation and corrosion and protects said multilayer reflective coating from oxidation, said second material being selected from the group consisting of Ru, Zr, Rh, Pd and any combination thereof, wherein said top overcoat layer and said bottom overcoat layer of said overcoat bilayer have optimum thicknesses selected such that reflectance of extreme ultraviolet or soft x-ray wavelengths is optimized at the wavelength range of operation and resistance to oxidation and corrosion is selected to preserve such reflectance.

8. The method of claim 7, wherein the deposition of the bottom overcoat layer or the top overcoat layer is carried out by vapor phase deposition.

9. The method of claim 7, wherein said plurality of alternating layers is an even plurality of alternating layers.

## Patentansprüche

1. Passivierende Überzugsdoppelschicht auf einer mehrlagigen, reflektierenden Beschichtung, bemessen zur Verwendung bei Anwendungen im extremen Ultraviolett oder weichen Röntgenstrahlen, aufweisend:
eine mehrlagige reflektierende Beschichtung, die eine Vielzahl alternierender Lagen eines Distanzmaterials (44) aufweist sowie eines Absorptionsmaterials (46), wobei die mehrlagige reflektierende Beschichtung eine oberste Lage (44) aufweist, die eine Oberseite hat, und eine unterste Lage aufweist, die eine Unterseite hat, und wobei die oberste Lage (44) das Distanzmaterial aufweist, wobei das Distanzmaterial Silicium ist;
ein Substrat, wobei die Unterseite der mehrlagigen, reflektierenden Beschichtung auf diesem Substrat abgeschieden ist;
eine untere Überzugsschicht (40), die auf der Oberseite der mehrlagigen, Beschichtung abgeschieden ist, und
eine obere Überzugsschicht (42), die auf der unteren Überzugsschicht abgeschieden ist und wobei die untere Überzugsschicht ein erstes Material aufweist, welches die Diffusion der oberen Überzugsschicht in die oberste Lage der mehrlagigen reflektierenden Beschichtung verhindert, wobei das erste Material B₄C ist oder eine beliebige Kombination davon, wobei die obere Überzugsschicht ein zweites Material aufweist, welches der Oxidation und Korrosion widersteht und die mehrlagige, reflektierende Beschichtung gegenüber Oxidation schützt, wobei das zweite Material ausgewählt ist aus der Gruppe, bestehend aus Ru, Zr, Rh, Pd und einer beliebigen Kombination davon, wobei die obere Überzugsschicht und die untere Überzugsschicht der Überzugsdoppelschicht eine optimale Dicke haben, die derart ausgewählt ist, dass der Reflexionsgrad für Wellenlängen des extremen Ultravioletts oder weicher Röntgenstrahlen für den Betriebswellenlängenbereich optimiert ist und die Beständigkeit gegenüber Oxidation und Korrosion gewählt wird, um einen solchen Reflexionsgrad zu bewahren.

2. Überzugsdoppelschicht nach Anspruch 1, wobei die obere Überzugsschicht und die untere Überzugsschicht Dicken haben, bei denen der Reflexionsgrad bei senkrechtem Einfall bei einer Betriebswellenlänge von weniger als etwa 15 Nanometer maximiert ist.

3. Überzugsdoppelschicht nach Anspruch 1, wobei die obere Überzugsschicht eine Dicke im Bereich von etwa 0,5 bis etwa 7 Nanometer hat.

4. Überzugsdoppelschicht nach Anspruch 1, wobei die untere Überzugsschicht eine Dicke im Bereich von etwa 0,5 bis etwa 7 Nanometer hat.

5. Überzugsdoppelschicht nach Anspruch 1, wobei das Absorptionsmaterial Molybdän aufweist.

6. Überzugsdoppelschicht nach Anspruch 1, wobei die Vielzahl alternierender Lagen eine geradzahlige Vielzahl von alternierenden Lagen ist.

7. Verfahren zum Erzeugen einer passivierenden Überzugsdoppelschicht auf einer mehrlagigen, reflektierenden Beschichtung, bemessen zur Verwendung bei Anwendungen im extremen Ultraviolett oder bei weicher Röntgenstrahlung, welches Verfahren umfasst:
Bereitstellen einer mehrlagigen, reflektierenden Beschichtung, die eine Vielzahl alternierender Lagen eines Distanzmaterials (44) aufweist sowie ein Absorptionsmaterial (46), wobei die mehrlagige, reflektierende Beschichtung eine oberste Lage (44) mit einer Oberseite aufweist und eine unterste Lage mit einer Unterseite, wobei die oberste Lage (44) das Distanzmaterials aufweist und das Distanzmaterial Silicium ist;
Bereitstellen eines Substrats, wobei die Unterseite der mehrlagigen Beschichtung auf dem Substrat abgeschieden ist;
Abscheiden einer unteren Überzugsschicht (40) auf der Oberseite der mehrlagigen Beschichtung, wobei die untere Überzugsschicht ein erste Material aufweist, mit dem ein Diffusionsübergang verringert oder vermieden wird, wobei das erste Material B₄C ist oder eine beliebige Kombination davon; sowie
Abscheiden einer oberen Überzugsschicht (42) auf der unteren Überzugsschicht, wobei untere Überzugsschicht ein zweites Material aufweist, das einer Oxidation und Korrosion widersteht und die mehrlagige, reflektierende Beschichtung gegenüber Oxidation schützt und wobei das zweite Material ausgewählt ist aus der Gruppe, bestehend aus Ru, Zr, Rh, Pd und einer beliebigen Kombination davon, wobei die obere Überzugsschicht und die untere Überzugsschicht der Überzugsdoppelschicht optimale Dicken haben, die derart ausgewählt sind, dass der Reflexionsgrad für Wellen im extremen Ultraviolett oder für weiche Röntgenstrahlen bei dem Betriebswellenlängenbereich optimiert ist und Beständigkeit gegenüber Oxidation und Korrosion gewählt wurden, um diesen Reflexionsgrad zu bewahren.

8. Verfahren nach Anspruch 7, wobei die Abscheidung der unteren Überzugsschicht oder der oberen Überzugsschicht mit Hilfe einer Dampfphasenabscheidung ausgeführt wird.

9. Verfahren nach Anspruch 7, wobei die Vielzahl alternierender Lagen eine geradzahlige Vielzahl von alternierenden Lagen ist.

## Revendications

1. Bicouche de surcouchage passivante sur un revêtement réfléchissant multicouche conçue pour être utilisée dans des applications d'ultraviolets extrêmes ou de rayons X mous, comprenant:
un revêtement réfléchissant multicouche comprenant une pluralité de couches alternées d'un matériau d'espaceur (44) et d'un matériau d'absorbeur (46), dans laquelle ledit revêtement réfléchissant multicouche comprend une couche la plus supérieure (44) ayant une surface supérieure et une couche la plus inférieure ayant une surface inférieure, dans laquelle ladite couche la plus supérieure (44) comprend ledit matériau d'espaceur, ledit matériau d'espaceur étant du silicium;
un substrat, dans lequel ladite surface inférieure dudit revêtement réfléchissant multicouche est déposée sur ledit substrat;
une couche de surcouchage inférieure (40) déposée sur ladite surface supérieure dudit revêtement réfléchissant multicouche; et
une couche de surcouchage supérieure (42) déposée sur ladite couche de surcouchage inférieure, dans laquelle ladite couche de surcouchage inférieure comprend un premier matériau qui empêche la diffusion de ladite couche de surcouchage supérieure dans ladite couche la plus supérieure dudit revêtement réfléchissant multicouche, dans laquelle ledit premier matériau est du B₄C ou toute combinaison de celui-ci, dans laquelle ladite couche de surcouchage supérieure comprend un second matériau qui résiste à l'oxydation et à la corrosion et protège ledit revêtement réfléchissant multicouche d'une oxydation, dans laquelle ledit second matériau est choisi dans le groupe constitué par Ru, Zr, Rh, Pd et toutes combinaisons de ceux-ci, dans laquelle ladite couche de surcouchage supérieure et ladite couche de surcouchage inférieure de ladite bicouche de surcouchage ont des épaisseurs optimales choisies de telle sorte que le facteur de réflexion des longueurs d'onde d'ultraviolets extrêmes ou de rayons X mous est optimisé à la gamme de longueur d'onde de fonctionnement et la résistance à l'oxydation et à la corrosion est choisie pour conserver un tel facteur de réflexion.

2. Bicouche de surcouchage selon la revendication 1, dans laquelle ladite couche de surcouchage supérieure et ladite couche de surcouchage inférieure ont des épaisseurs qui maximisent le facteur de réflexion sous incidence normale à une longueur d'onde de fonctionnement inférieure à environ 15 nanomètres.

3. Bicouche de surcouchage selon la revendication 1, dans laquelle ladite couche de surcouchage supérieure a une épaisseur s'étendant d'environ 0,5 nanomètre à environ 7 nanomètres.

4. Bicouche de surcouchage selon la revendication 1, dans laquelle ladite couche de surcouchage inférieure a une épaisseur s'étendant d'environ 0,5 nanomètre à environ 7 nanomètres.

5. Bicouche de surcouchage selon la revendication 1, dans laquelle ledit matériau d'absorbeur comprend du molybdène.

6. Bicouche de surcouchage selon la revendication 1, dans laquelle ladite pluralité de couches alternées est une pluralité régulière de couches alternées.

7. Procédé de formation d'une bicouche de surcouchage passivante sur un revêtement réfléchissant multicouche conçue pour être utilisée dans des applications d'ultraviolets extrêmes ou de rayons X mous, comprenant:
la formation d'un revêtement réfléchissant multicouche comprenant une pluralité de couches alternées d'un matériau d'espaceur (44) et d'un matériau d'absorbeur (46), dans lequel ledit revêtement réfléchissant multicouche comprend une couche la plus supérieure (44) ayant une surface supérieure et une couche la plus inférieure ayant une surface inférieure, dans lequel ladite couche la plus supérieure (44) comprend ledit matériau d'espaceur, ledit matériau d'espaceur étant du silicium;
la formation d'un substrat, dans lequel ladite surface inférieure dudit revêtement réfléchissant multicouche est déposée sur ledit substrat;
le dépôt sur ladite surface supérieure dudit revêtement multicouche d'une couche de surcouchage inférieure (40) comprenant un premier matériau qui réduira ou empêchera l'interdiffusion, ledit premier matériau étant du B₄C ou toutes combinaisons de celui-ci; et
le dépôt sur ladite couche de surcouchage inférieure d'une couche de surcouchage supérieure (42) comprenant un second matériau qui résiste à l'oxydation et à la corrosion et protège ledit revêtement réfléchissant multicouche d'une oxydation, ledit second matériau étant choisi dans le groupe constitué par Ru, Zr, Rh, Pd et toutes combinaisons de ceux-ci, dans lequel ladite couche de surcouchage supérieure et ladite couche de surcouchage inférieure de ladite bicouche de surcouchage ont des épaisseurs optimales choisies de telle sorte que le facteur de réflexion des longueurs d'onde d'ultraviolets extrêmes ou de rayons X mous est optimisé à la gamme de longueur d'onde de fonctionnement et la résistance à l'oxydation et à la corrosion est choisie pour conserver un tel facteur de réflexion.

8. Procédé selon la revendication 7, dans lequel le dépôt de la couche de surcouchage inférieure ou de la couche de surcouchage supérieure est réalisé par dépôt en phase vapeur.

9. Procédé selon la revendication 7, dans lequel ladite pluralité de couches alternées est une pluralité régulière de couches alternées.
